# EUROPEAN PATENT SPECIFICATION

(11) **EP 0 953 065 B1**
(45) Date of publication and mention of the grant of the patent: **15.01.2003**
(21) Application number: 97939305.5
(22) Date of filing: 05.09.1997
(51) Int. Cl.: C23C 16/30, C23C 16/40, C23C 30/00

(54) **COATED CUTTING INSERT**
BESCHICHTETER SCHNEIDEINSATZ
PLAQUETTE AMOVIBLE ENDUITE POUR OUTIL DE COUPE

(30) Priority: 06.09.1996 SE 9603264
(43) Date of publication of application: 03.11.1999
(73) Proprietor: SANDVIK AKTIEBOLAG, 811 81 Sandviken (SE)
(72) Inventor: KUTSCHER, Asa, S-125 30 Älvsjö (SE); WESTERGREN, Kenneth, S-129 42 Hägersten (SE); LJUNGBERG, Björn, S-122 44 Enskede (SE); LENANDER, Anders, S-135 53 Tyresö (SE)
(74) Representative: Taquist, Lennart
(86) International application number: PCT/SE97/01489
(87) International publication number: WO 98/010119

(56) References cited:
- EP-A- 0 498 781
- EP-A- 0 603 144
- EP-A- 0 685 572
- EP-A- 0 693 574
- US-A- 5 310 605
- PATENT ABSTRACTS OF JAPAN, Vol. 9, No. 260, (C-309), 17 Oct. 1985; & JP,A,60 110 840 (SUMITOMO DENKI KOGYO KK), 17 June 1985.

## Description

The present invention relates to a coated cutting tool (cemented carbide insert) particularly useful for machining of cast iron parts by turning.

Cast iron materials may be divided into two main categories, grey cast iron and nodular cast iron. Cast iron materials typically often have an outer layer of cast skin, which may contain various inclusions of sand, rust and other impurities, but also a surface zone which is decarburized and contains a larger amount of ferrite than the rest of the material.

The wear when machining grey cast iron materials with Al₂O₃-coated cutting tools is dominated by chemical, abrasive and so called adhesive wear. In order to protect the cutting tool against chemical wear it is desirable to use as thick Al₂O₃-layers as possible. This is contradicted by the properties regarding adhesive wear that this type of layer generally possesses. Adhesive wear occurs when fragments or individual grains of the layer are pulled away from the cutting edge by the work piece chip formed. Especially the surface zone with high amounts of ferrite puts severe demands on the adhesive properties of the coating, and in combination with the inclusions in the cast skin on the work piece this causes notch wear at the depth of cut at the main cutting edge.

Another critical factor in the machining of grey cast iron is the sensitivity for excessive amounts of Co binder phase in the interface between the cemented carbide cutting insert and the coating. Excessive amounts of Co binder phase deteriorate the adhesion between coating and cemented carbide and lead to flaking of the coating during machining.

EP-A-753 603 discloses a coated cutting insert tool consisting of a cemented carbide body of a composition 5-11 wt-% Co, <10%, preferably 1.5-7.5 wt-%, cubic carbides of the metals Ti, Ta and/or Nb and balance WC, especially suited for machining of low alloyed steel components by turning.

EP-A-685 572 discloses a coated hard alloy cutting tool insert which includes a substrate formed of a hard alloy of a WC-based cemented carbide or a TiCN-based cermet, and a hard coating deposited on the substrate. The hard coating includes an inner layer of TiCN having unilaterally grown crystals of an elongated shape and an outer layer of Al₂O₃ having a crystal form κ or κ + α wherein κ > α. The resulting insert is highly resistant to wear and fracturing, and possesses cutting ability of a higher level.

EP-A-603 144 discloses a body coated with refractory single-or multilayers, wherein specific layers are characterized by a controlled microstructure and phase composition with crystal planes preferably grown in a preferential direction with respect to the surface of the coated body. Said coating comprises one or several refractory layers of which at least one layer is a dense, fine-grained layer of α-Al₂O₃ preferably textured in the (012) direction. The coated tool according to the invention exhibits excellent surface finish and shows much improved wear and toughness properties compared to prior art objects when used for machining steel, cast iron and, particularly, when machining nodular cast iron.

It has surprisingly been found that by combining the following features: a cemented carbide body with a highly W-alloyed binder phase, a low content of cubic carbides and a well defined surface composition resulting from a specific sintering process, a columnar TiCₓN_{y}O_{z}-layer, a textured α-Al₂O₃-layer, a TiCₓN_{y}O_{z}-layer, fulfilling the demands of easy identification of used edges, and a post-treatment of the coated cutting edge by brushing, an excellent cutting tool for machining of cast iron materials, especially grey cast iron, can be obtained.

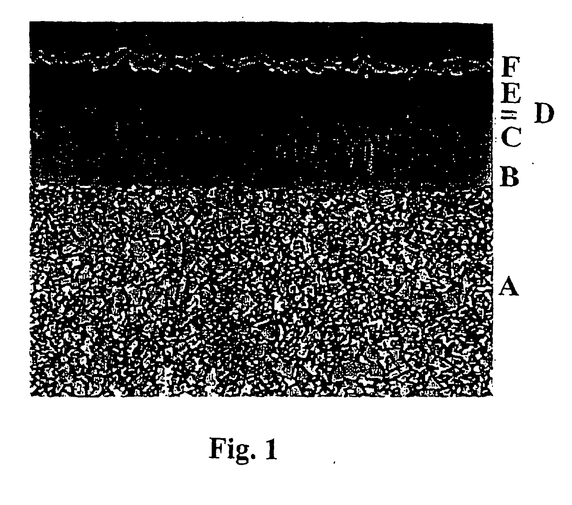

Fig 1 is a micrograph in 2000X magnification of a coated insert according to the present invention in which
A - cemented carbide body
B - TiCₓN_{y}O_{z}-layer with equiaxed grains
C - TiCₓN_{y}O_{z}-layer with columnar grains
D - TiCₓN_{y}O_{z}-layer with equiaxed or needle like grains
E - textured α-Al₂O₃-layer with columnar like grains
F - layer

According to the present'invention a cutting tool insert is provided with a cemented carbide body of a composition 5-10 wt-% Co <0.5 wt-%, from group IVb, Vb or VIb of the periodic table (Deming 1923) cubic carbides of the metals and balance WC. The grain size of the WC is in the range of 1-2.5 µm. The cobalt binder phase is highly alloyed with W. The content of W in the binder phase can be expressed as the${\text{CW-ratio= M}}_{\text{S}} \text{/(wt-% Co · 0.0161),}$ where Mₛ is the measured saturation magnetization of the cemented carbide body in kA/m and
wt-% Co is the weight percentage of Co in the cemented carbide. The CW-value is a function of the W content in the Co binder phase. A low CW-value corresponds to a high W-content in the binder phase.

It has now been found according to the present invention that improved cutting performance is achieved if the cemented carbide body has a CW-ratio of 0.80-0.90. The cemented carbide body may contain small amounts, <1 volume-%, of eta phase (M₆C), without any detrimental effect.

The surface composition of the cemented carbide insert is well defined and the amount of Co on the surface is within -4 wt% to +4 wt% of the nominal content.

The coating comprises
- a first (innermost) layer of TiCₓN_{y}O_{z} with x+y+z=1, y>x and z<0.1, with a thickness of 0.1-2 µm, and with equiaxed grains with size <0.5 µm.
- a layer of TiCₓN_{y} x+y=1, with x>0.3 and y>0.3 with a thickness of 5-10 µm, with columnar grains and with a diameter of <2 µm
- a layer of TiCₓN_{y}O_{z}, x+y+z=1 with z<0.5, x>y, with a thickness of 0.1-2 µm and with equiaxed or needle-like grains with size <0.5 µm, this layer being the same as or different from the innermost layer
- a layer of textured, fine-grained (with average grain size 0.5-2 µm) α-Al₂O₃ with a thickness of 3-6 µm and
- an outer layer of TiCₓN_{y}O_{z}. This TiCₓN_{y}O_{z}-layer comprises one or more layers with the composition x+y+z=1, z<0.05 and y>x. Alternatively, this outer layer can be a multilayer of TiN/TiC/TiN in one or several sequences and a total thickness of 0.5-3 µm. This layer exhibits a grain size <1 µm.

In order to obtain a smooth cutting edge line suitable for machining, the edge of the coated insert is subjected to a brushing treatment giving a surface roughness Rₘₐₓ≤0.4 µm over a length of 10 µm according to the method described in EP-A-693 574. This treatment removes the top layer of TiCₓN_{y}O_{z} along the cutting edge line. It is also within the scope of this invention that the surface might be smoothed by a wet blasting treatment.

Furthermore, as disclosed in US 5,654,035 or EP-A-6 59 903 or EP-A-738 336 the α-Al₂O₃-layer has a preferred crystal growth orientation in either the (104)-, (012)- or (110)-direction, preferably in the (012)-direction, as determined by X-ray Diffraction (XRD) measurements. A Texture Coefficient, TC, can be defined as: 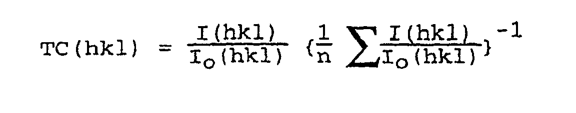 where
I(hkl) = measured intensity of the (hkl) reflection
Iₒ(hkl) = standard intensity of the ASTM standard powder
pattern diffraction data
n = number of reflections used in the calculation, (hkl)
reflections used are: (012), (104), (110), (113), (024), (116)
TC for the set of (012), (104) or (110) crystal planes ought to be larger than 1.3, preferably larger than 1.5.

According to method of the invention a WC-Co-based cemented carbide body consisting of WC with a grain size of 1-2.5 µm, 5-10 wt-% Co and <0.5 wt-% cubic carbides of metals from group IVb, Vb or VIb of the periodic table (Deming 1923) and a highly W-alloyed binder phase with a CW-ratio of 0.8-09 is subjected to a sintering process including a cooling step which at least to below 1200 °C is performed in a hydrogen atmosphere of pressure 0.4-0.9 bar as disclosed in WO 98/02396.

The insert is coated with
- a first (innermost) layer of TiCₓN_{y}O_{z} with x+y+z=1, y>x and z<0.1, with a thickness of 0.1-2 µm, and with equiaxed grains with size <0.5 µm.
- a layer of TiCₓN_{y}O_{z} x+y=1, with, x>0.3 and y>0.3, with a thickness of 5-10 µm, with columnar grains with a diameter of <2 µm, deposited by MTCVD-technique (using acetonitrile as the carbon and nitrogen source for forming the layer in the temperature range of 700-900 °C). The exact conditions, however, depend to a certain extent on the design of the equipment used.
- a layer of TiCₓN_{y}O_{z}, x+y+z=1 with z<0.5, x>y, with a thickness of 0.1-2 µm and with equiaxed or needle like grains with size <0.5 µm, using known CVD-methods this layer being the same as or different from the innermost layer.
- an intermediate layer of a smooth textured α-Al₂O₃ according to US 5, 654, 035 EP-A-659 903 or EP-A-738 336 with a thickness of 3-6 µm.
- an outer layer of TiCₓN_{y}O_{z}, comprising one or several individual layers each with composition x+y+z=1 and z<0.05 and y>x. Alternatively, this outer layer can be a multilayer of TiN/TiC/TiN in one or several sequences. The total coating thickness of these outer layers is 0.5-3.0 µm. The grain size in this outer layers is <1.0 µm.

The edge line of the inserts is smoothed e g by brushing the edges with brushes based on e g SiC as been disclosed in EP-A-693 544.

When a TiCₓN_{y}O_{z}-layer with z>0 is desired, CO₂ and/or CO are/is added to the reaction gas mixture.

### Example 1

A. Cemented carbide cutting tool inserts of style CNMG 120412-KM with the composition 6.0 wt-% Co and balance WC were sintered in a conventional way at 1410°C and cooled down to 1200°C in 0.6 bar H₂ giving inserts with a binder phase highly alloyed with W, corresponding to a CW-ratio of 0.85 and a Co-content on the surface corresponding to 7 wt-% as measured with Energy Dispersive Spectroscopy. After conventional ER-treating the inserts were coated with a 0.5 µm equiaxed TiCₓN_{y}O_{z}-layer, x=0.1, y=0.9, z=0 and an average grain size of about 0.2 µm, followed by a 8.0 µm thick TiCₓN_{y}-layer x=0.55, y=0.45, with columnar grains with an average grain size of 2.5 µm, by using MTCVD-technique (process temperature 850 °C and CH₃CN as the carbon/nitrogen source). In subsequent process steps during the same coating cycle, a 1 µm thick layer of TiCₓN_{y}O_{z} (about x=0.6, y=0.2 and z=0.2) with equiaxed grains and an average grain size of 0.2 µm was deposited followed by a 5.0 µm thick layer of (012)-textured α-Al₂O₃, with average grain size of about 1.2 µm, deposited according to conditions given in US 5,654,035. On top of the α-Al₂O₃-layer, TiN/TiC/TiN/TiC/TiN was deposited in a multilayer. structure with a total coating thickness of 1.5 µm and average grain size <0.3 µm in each individual layer. Finally, the inserts were subjected to a brushing treatment in which the cutting edge lines were smoothed with a 320 mesh brush containing SiC as grinding material, the outer TiN/TiC-multilayer was removed by the brushing treatment along the cutting edge line.
B. Cemented carbide cutting tool inserts of style CNMG 120412-KM with the composition 6.0 wt-% Co and balance WC were coated under the procedure as described in A). The inserts had a CW-ratio of 0.88 and they were subjected to a conventional sintering without H₂ during the cooling step. Prior to the coating process the inserts were subjected to surface cleaning process involving an electrolytic etching process according to US 5,380,408. The Co content on the insert surface was about 5 wt-% as measured with Energy Dispersive Spectroscopy. The cemented carbide had an about 250 mym wide binder phase depleted surface zone in which the binder phase content increased monotonously and in a non-step-wise manner without maximum up to the nominal content in the inner of the cemented carbide. The average binder phase content in a 25 mym surface zone was 3 wt-%. The inserts were subjected to the same final brushing treatment as in A.).
C. Cemented carbide cutting tool inserts of style CNMG120412-KM from the same batch as in A.) were coated with a 4 µm equiaxed TiC-layer with grain size <2.0 µm followed by a 6 µm thick layer of Al₂O₃ according to prior art technique. XRD-analysis showed that the Al₂O₃-layer consisted of a mixture of α and κ-Al₂O₃, in the ratio of about 60/40. The α-Al₂O₃ showed no preferred growth orientation as measured by XRD. The grain size of the κ-Al₂O₃ was 2.0 µm while the α-Al₂O₃ exhibited grains up to 5.5 µm.
D. Cemented carbide cutting tool inserts from the same batch as in C. The inserts had been subjected to a wet blasting treatment after coating.
E. Cemented carbide cutting tool inserts of style CNMG120412-KM from the same batch as in A.) were coated with a 2 µm equiaxed layer of TiCₓN_{y}O_{z}, the average grain size of which was 0.2 µm, followed by a 8 µm thick columnar TiCN deposited according to prior art technique with a grain size of about 3.0 µm and a 6 µm thick layer of (012)-textured α-Al₂O₃ deposited according to the same process conditions as in A.). The inserts were subjected to the same brushing treatment as in A.).
F. Cemented carbide cutting tool inserts of style CNMG120412-KM with the composition 6 wt-% Co, 4 wt-% cubic carbides and balance WC were subjected to the same coating process as in A.) The CW-ratio of the inserts was 0.88 and they were subjected to a sintering process using H₂ during the cooling step, the Co content on the surface was 9% as measured by Energy Dispersive Spectroscopy. The inserts were subjected to the same final brushing treatment as in A.).
G. Cemented carbide cutting inserts of style CNMG120412-KM with the composition 6.0 weight % Co and balance WC were coated under the procedure described in insert E. The cemented carbide had a CW-ratio of 0.98 and the inserts were subjected to a conventional sintering without H2 during the cooling step. The inserts were ER-treated and cleaned in conventional processes. The Co content on the surface prior to coating was 30 weight % as measured with Energy Dispersive Spectroscopy. The inserts were subjected to the same final brushing treatment as in insert A.

The inserts were tested in a facing operation. The work piece material was nodular cast iron, SS717. The workpiece shape causes intermittent cutting conditions during each revolution. Cutting speed was 250 m/min, feed 0.10 mm/rev and cutting depth 2.0 mm. The operation was performed using coolant.

This type of operation typically causes severe flaking of the coating. The coating is torn off the insert in fragments. The wear can be measured as the part of the edge line on which the coating has flaked off compared to the total length of the edge line used in the cutting operation.

| Insert type | % of edge line with flaking |
|---|---|
| A | <5 |
| B | <5 |
| C | 100 |
| D | 70 |
| E | 25 |
| F | 20 |
| G | 50 |

### Example 2.

Inserts of type A, B, D and E in Example 1 above were tested in an intermittent cutting operation in grey cast iron, SS0125. The cutting conditions put high demands on the flaking resistance of the coating as well as the chemical and abrasive wear resistance of the coating. The shaping of the work piece is such that for each revolution two entrances in the work piece will be made giving intermittent cutting conditions. The cutting speed was 300 m/min, the cutting feed 0.25 mm/rev and the cutting depth 2.0 mm. The machining was made without using any coolant.

| Insert type | number of passes before the edge was worn out |
|---|---|
| A | 60 |
| B | 55 |
| D | 48 |
| E | 48 |

### Example 3.

The same cutting conditions as in example 2 and inserts of type A, B, C, D, and F from the same batches as in example 1. In this test coolant was used during machining.

| Insert type | number of passes state of the edge | |
|---|---|---|
| A | 60 | minor chipping of edge line, not worn out |
| B | 60 | undamaged edge line not worn out |
| C | 48 | fracture in cutting edge, insert worn out |
| D | 24 | fracture in cutting edge, insert worn out |
| F | 24 | fracture in cutting edge, insert worn out |

### Example 4.

Cemented carbide inserts of type A, B and G in example 1 above were tested in a turning test that causes deformation of the cutting edge leading to flaking of the coating and enhanced wear of the insert. The test was performed in a nodular cast iron SS0737 and for a certain combination of feed and cutting depth in a longitudinal turning operation. The highest possible cutting speed before deformation of the cemented carbide occurs was sought.

| Insert type | Highest possible cutting speed, m/min |
|---|---|
| A | 475 |
| B | 450 |
| G | 400 |

## Claims

1. A cutting tool insert comprising a coating and a cemented carbide body **characterized in that** said cemented carbide body consists of WC with a grain size of 1-2.5 µm, 5-10 wt-% Co and <0.5 wt% cubic carbides of metals from group IVb, Vb or VIb of the periodic table (Deming 1923) and a highly W-alloyed binder phase with a CW-ratio of 0.8-0.9 with <1 vol-% eta-phase and a surface composition of the cemented carbide body being well defined the amount of Co on the surface being within -4 wt% to +4 wt% of the nominal Co-content and **in that** said coating comprises
- a first, innermost layer of TiCₓN_{y}O_{z} with a thickness of 0.1-2 µm and with equiaxed grains with size <0.5 µm with x+y+z=1 and y>x and z<0.1
- a layer of TiCₓN_{y} where x+y=1, x>0.3 and y>0.3, with a thickness of 5-10 µm with columnar grains with a diameter of <2 µm
- a layer of TiCₓN_{y}O_{z} where x+y+z=1, z<0.5 and x>y with a thickness of 0.1-2 µm and with equiaxed or needle-like grains with size <0.5 µm
- a layer of a smooth α-Al₂O₃ textured in the direction (012), (104) or (110) with a thickness of 3-6 µm and with a grain size 0.5-2 µm
- an outer layer of
- TiCₓN_{y}O_{z} x+y+z=1, z<0.05 with a thickness of 0.5-3 µm and a grain size <1 µm or
- a multilayer of TiN/TiC/TiN in one or several sequences with a total thickness of 0.5-3 µm and a grain size <1 µm.
and **in that** the outer coating layer has been removed in at least the edge line so that the Al₂O₃-layer is on top along the cutting edge line and said outer layer is the top layer on the clearance side.

2. Cutting insert according to the preceding claim **characterized in that** the α-Al₂O₃-layer has a texture in (012)-direction and with a texture coefficient TC(012) larger than 1.3.

3. Method of making a cutting insert comprising a cemented carbide body and a coating for turning of cast iron **characterized in that** a cemented carbide body consisting of WC with a grain size of 1-2.5 µm, 5-10 wt-% Co and <0.5 wt-% cubic carbides of metals from group IVb, Vb or VIb of the periodic table (Deming 1923) and a highly W-alloyed binder phase with a CW-ratio of 0.8-0.9 with < 1 vol-% eta-phase is subjected to a sintering process including a cooling step which at least to below 1200 °C is performed in a hydrogen atmosphere of pressure 0.4-0.9 bar and thereafter coated with
- a first, innermost layer of TiCₓN_{y}O_{z} with a thickness of 0.1-2 µm and with equiaxed grains with size <0.5 µm with x+y+z=1 and y>x and z<0.1 using known CVD-methods
- a layer of TiCₓN_{y} where x+y=1, x>0.3 and y>0.3, with a thickness of 5-10 µm with columnar grains with a diameter of <2 µm by MTCVD-technique, using acetonitrile as the carbon and nitrogen source for forming the layer in a temperature range of 700-900 °C.
- a layer of TiCₓN_{y}O_{z} where x+y+z=1, z<0.5 and x>y with a thickness of 0.1-2 µm and with equiaxed or needle-like grains with size <0.5 µm, using known CVD-methods
- a layer of a smooth textured α-Al₂O₃ textured in the direction (012), (104) or (110) with a thickness of 3-6 µm using known CVD-methods
- an outer layer of
- TiCₓN_{y}O_{z} x+y+z=1, z<0.05 with a thickness of 0.5-3 µm and a grain size <1 µm or
- a multilayer of TiN/TiC/TiN in one or several sequences with a total thickness of 0.5-3 µm and a grain size <1 µm.
- said outer layer being removed by brushing or blasting in at least the cutting edge line so that the Al₂O₃-layer is on top along the cutting edge line and the outer layer of TiCₓN_{y}O_{z} is the top layer on the clearance side of the cutting insert.

4. Method of making a cutting tool insert according to claim 3 **characterized in that** the α-Al₂O₃-layer has a texture in (012)-direction and with a texture coefficient TC(012) larger than 1.3.

## Patentansprüche

1. Schneidwerkzeugeinsatz mit einer Beschichtung und einem Hartmetallkörper, **dadurch gekennzeichnet, dass** dieser Hartmetallkörper aus WC mit einer Korngröße von 1 bis 2,5 µm, 5 bis 10 Gew.% Co und <0,5 Gew.% kubischen Carbiden von Metallen aus der Gruppe IVb, Vb oder VIb des Periodensystems (Deming 1923) und eine stark W-legierte Bindemittelphase mit einem CW-Verhältnis von 0,8 bis 0,9 mit <1 Vol.% eta-Phase und mit einer Oberflächenzusammensetzung des Hartmetallkörpers besteht, die bezüglich der Co-Menge auf der Oberfläche innerhalb von -4 Gew.% bis +4 Gew.% des nominalen Co-Gehaltes definiert ist, und dass die Beschichtung
- eine erste innerste Schicht von TiCₓN_{y}O_{z} mit einer Dicke von 0,1 bis 2 µm und mit gleichachsigen Körnern mit einer Größe von <0,5 µm, wobei x + y + z = 1 und y > x und z < 0,1,
- eine Schicht von TiCₓN_{y}, worin x + y = 1, x > 0,3 und y > 0,3 bedeutet, mit einer Dicke von 5 bis 10 µm mit säulenartigen Körnern mit einem Durchmesser von <2 µm,
- eine Schicht von TiCₓN_{y}O_{z}, worin x + y + z = 1, z < 0,5 und x > y, mit einer Dicke von 0,1 bis 2 µm und mit gleichachsigen oder nadelartigen Körnern mit einer Größe von <0,5 µm,
- eine Schicht eines glatten α-Al₂O₃, in der Richtung (012), (104) oder (110) texturiert, mit einer Dicke von 3 bis 6 µm und mit einer Korngröße von 0,5 bis 2 µm,
- eine Außenschicht von
- TiCₓN_{y}O_{z}, wobei x + y + z = 1, z < 0,05 mit einer Dicke von 0,5 bis 3 µm und einer Korngröße <1 µm oder
- mehrere Schichten von TiN/TiC/TiN in einer oder mehreren Sequenzen mit einer Gesamtdicke von 0,5 bis 3 µm und einer Korngröße <1 µm umfaßt,
und dass die äußere Überzugsschicht wenigstens von der Kantenlinie derart entfernt wurde, dass die Al₂O₃-Schicht entlang der Schneidkantenlinie eine Deckschicht bildet.

2. Schneideinsatz nach dem vorausgehenden Anspruch, **dadurch gekennzeichnet, dass** die α-Al₂O₃-Schicht eine Textur in der (012)-Richtung hat und der Texturkoeffizient TC (012) größer als 1,3 ist.

3. Verfahren zur Herstellung eines Schneideinsatzes mit einem Hartmetallkörper und einer Beschichtung zum Drehen von Gusseisen, **dadurch gekennzeichnet, dass** ein Hartmetallkörper, der aus WC mit einer Korngröße von 1 bis 2,5 µm, 5 bis 10 Gew.% Co und <0,5 Gew.% kubischen Carbiden von Metallen aus der Gruppe IVb, Vb oder VIb des Periodensystems (Deming 1923) und einer stark W-legierten Bindemittelphase mit einem CW-Verhältnis von 0,8 bis 0,9 mit <1 Vol.% eta-Phase einem Sinterverfahren einschließlich einer Kühlstufe unterzogen wird, welche wenigstens unter 1200 °C in einer Wasserstoffatmosphäre bei einem Druck von 0,4 bis 0,9 bar unterzogen wird und danach
- mit einer ersten innersten Schicht von TiCₓN_{y}O_{z} mit einer Dicke von 0,1 bis 2 µm und mit gleichachsigen Körnern mit einer Größe von <0,5 µm, wobei x + y + z = 1 und y > x und z < 0,1 ist, unter Verwendung bekannter CVD-Methoden,
- mit einer Schicht von TiCₓN_{y}, worin x + y = 1, x > 0,3 und y > 0,3 ist, mit einer Dicke von 5 bis 10 µm mit säulenartigen Körnern mit einem Durchmesser von <2 µm nach MTVD-Technik unter Verwendung von Acetonitril als die Kohlenstoff und Stickstoff liefernde Quelle zur Bildung der Schicht in einem Temperaturbereich von 700 bis 900 °C,
- mit einer Schicht von TiCₓN_{y}O_{z}, worin x + y + z = 1, z < 0,5 und x > y, mit einer Dicke von 0,1 bis 2 µm und mit gleichachsigen oder nadelartigen Kömern in der Größe von <0,5 µm unter Verwendung bekannter CVD-Methoden,
- mit einer Schicht eines glatten texturierten α-Al₂O₃, welches in der Richtung (012), (104) oder (110) mit einer Dicke von 3 bis 6 µm unter Verwendung bekannter CVD-Methoden,
- mit einer Außenschicht von
- mit TiCₓN_{y}O_{z}, x + y + z = 1, z < 0,05 mit einer Dicke von 0,5 bis 3 µm und einer Korngröße <1 µm oder
- mit mehreren Schichten von TiN/TiC/TiN in einer oder mehreren Folgen mit einer Gesamtdicke von 0,5 bis 3 µm und einer Korngröße <1 µm be- schichtet wird, wobei
- die äußere Schicht durch Bürsten oder Sandstrahlen in wenigstens der Schneidkantenlinie so entfernt wird, dass die Al₂O₃-Schicht entlang der Schneidkantenlinie Deckschicht ist und die äußere Schicht von TiCₓN_{y}O_{z} auf der Abstandsseite des Schneideinsatzes Deckschicht ist.

4. Verfahren zur Herstellung eines Schneidwerkzeugeinsatzes nach Anspruch 3, **dadurch gekennzeichnet, dass** die α-Al₂O₃-Schicht eine Textur in der (012)-Richtung mit einem Texturkoeffizienten TC (012) größer als 1,3 hat.

## Revendications

1. Plaquette d'outil de coupe comprenant un revêtement et un corps de carbure cémenté **caractérisée en ce que** le corps de carbure cémenté est constitué de WC avec une taille de grain de 1 à 2,5 µm, 5 à 10% en poids de Co et moins de 0,5% en poids de carbures cubiques de métaux des groupes IVb, Vb ou VIb du tableau périodique (Deming 1923) et une phase de liant hautement alliée avec W avec un rapport CW de 0,8 à 0,9 avec moins de 1% en volume de phase éta et une composition de surface du corps de carbure cémenté body étant bien définie, la quantité de Co sur la surface étant comprise entre -4% en poids et +4% en poids de la teneur nominale en Co et **en ce que** le revêtement comprend
- une première couche la plus interne de TiCₓN_{y}O_{z} avec une épaisseur de 0,1 à 2 µm, et avec des grains équiaxiaux d'une taille inférieure à 0,5 µm avec x+y+z=1, y>x et z<0,1,
- une couche de TiCₓN_{y} où x+y=1, x>0,3 et y>0,3, avec une épaisseur de 5 à 10 µm avec des grains colonnaires d'un diamètre inférieur à 2 µm,
- une couche de TiCₓN_{y}O_{z}, où x+y+z=1 avec z<0,5, x>y, avec une épaisseur de 0,1 à 2 µm et avec des grains équiaxiaux ou analogues à des aiguilles avec une taille inférieure à 0,5 µm,
- une couche de Al₂O₃α lisse texturée, texturée dans la direction (012), (104) ou (110) avec une épaisseur de 3 à 6 µm et avec une taille de grain de 0,5 à 2 µm
- une couche externe de
- TiCₓN_{y}O_{z} x+y+z=1, z<0,05 et y>x avec une épaisseur de 0,5 à 3 µm et une taille de grain inférieure à 1 µm, ou
- une multicouche de TiN/TiC/TiN en une ou plusieurs séquences avec une épaisseur totale de 0,5 à 3 µm et une taille de grain inférieure à 1
et **en ce que** la couche de revêtement externe a été retirée dans au moins la ligne d'arête de sorte que la couche de Al₂O₃ est sur le dessus de la ligne d'arête tranchante et
ladite couche extérieure est la couche du dessus sur le côté dépouille.

2. Plaquette de coupe selon la revendication précédente, **caractérisée en ce que** la couche Al₂O₃α possède une texture dans la direction (012) et avec un coefficient de texture TC (012) supérieur à 1,3.

3. Procédé de fabrication de plaquette de coupe comprenant un corps de carbure cémenté et un revêtement de tournage de fonte, **caractérisé en ce qu'**on soumet un corps de carbure cémenté constitué de WC avec une taille de grain de 1 à 2,5 µm, de 5 à 10% en poids de Co et moins de 0,5% en poids de carbures cubiques de métaux des groupes IVb, Vb ou VIb du tableau périodique (Deming 1923) et une phase de liant hautement alliée avec W avec un rapport CW de 0,8 à 0,9, avec moins de 1% en volume de phase éta à un procédé de frittage comprenant une étape de refroidissement qui, au moins au-dessous de 1200°C, est réalisé dans une atmosphère d'hydrogène sous 0,4 à 0,9 bar de pression et que l'on le revêt ensuite de
- une première couche interne de TiCₓN_{y}O_{z} avec une épaisseur de 0,1 à 2 µm et avec des grains équiaxiaux d'une taille inférieure à 0,5 µm, avec x+y+z=1 et y>x et z<0,1, en utilisant des procédés CVD connus
- une couche de TiCₓN_{y}O_{z} où x+y=1, x>0,3 et y>0,3, avec une épaisseur de 5 à 10 µm, avec des grains colonnaires de diamètre inférieur à 2 µm, au moyen d'une technique MTCVD, en utilisant de l'acétonitrile en tant que source de carbone et d'azote pour former la couche dans une gamme de température de 700°C à 900°C.
- une couche de TiCₓN_{y}O_{z} où x+y+z=1, z<0,5 et x>y avec une épaisseur de 0,1 à 2 µm et avec des grains équiaxiaux ou analogues à des aiguilles avec une taille inférieure à 0,5 µm, en utilisant des procédés CVC connus
- une couche de Al₂O₃α lisse texturée dans la direction (012), (104) ou (110) avec une épaisseur de 3 à 6 µm en utilisant des procédés CVD connus
- une couche externe de
- TiCₓN_{y}O_{z} x+y+z=1, z<0,05 avec une épaisseur de 0,5 à 3 µm et une taille de grain inférieure à 1,0 µm ou
- une multicouche de TiN/TiC/TiN en une ou plusieurs séquences avec une épaisseur totale de 0,5 à 3 µm et une taille de grain inférieure à 1 µm.
ladite couche externe étant retirée par brossage ou sablage dans au moins la ligne d'arête tranchante de sorte que la couche de Al₂O₃ est sur le dessus, le long de la ligne de l'arête tranchante et la couche externe de TiCₓN_{y}O_{z} est la couche du haut sur le côté dépouille de la plaquette de coupe.

4. Procédé de fabrication d'une plaquette d'outil de coupe selon la revendication 3 **caractérisé en ce que** la couche de Al₂O₃α possède une texture dans la direction (012) et avec un coefficient de texture TC (012) supérieur à 1,3.
